# EUROPEAN PATENT APPLICATION

(11) **EP 4 549 636 A1**
(43) Date of publication of application: **07.05.2025**
(21) Application number: 24772197.0
(22) Date of filing: 29.04.2024
(51) Int. Cl.: C30B 23/00

(54) **SILICON CARBIDE GROWTH DEVICE AND GROWTH METHOD**

(30) Priority: 25.06.2023 CN 202310745511
(71) Applicant: Tongwei Microelectronics Co., Ltd., Chengdu, Sichuan 610299 (CN)
(72) Inventor: BA, Yintu, Chengdu, Sichuan 610299 (CN); HU, Mingli, Chengdu, Sichuan 610299 (CN)
(74) Representative: Garavelli, Paolo
(86) International application number: PCT/CN2024/090476
(87) International publication number: WO 2025/001481

(57) **Abstract**

The present disclosure provides an apparatus and method for growing silicon carbide, and relates to the technical field of growth of silicon carbide crystals. The apparatus for growing the silicon carbide includes a growth crucible, a heating apparatus, a seed crystal positioning cover, a positioning frame, a weighing apparatus and a bearing connector, wherein the seed crystal positioning cover is connected with the weighing apparatus through the bearing connector, and the seed crystal positioning cover and the growth crucible are in clearance fit, such that the growth crucible is prevented from supporting the seed crystal positioning cover, the weighing apparatus can hoist the seed crystal positioning cover through the bearing connector, and accordingly, the seed crystal positioning cover, the seed crystals and the grown silicon carbide crystals may only act on the weighing apparatus; the weights of the seed crystal positioning cover, the seed crystals and the silicon carbide crystals are measured in real time through the weighing apparatus, and the weights of the seed crystal positioning cover and the seed crystals are constant, such that the weight of silicon carbide crystals can be precisely measured in real time, processes can be adjusted based on this, and therefore the growth quality of the silicon carbide crystals is improved.

## Description

### TECHNICAL FIELD

The present disclosure relates to the technical field of silicon carbide crystal growth, in particular to an apparatus and method for growing silicon carbide.

### BACKGROUND ART

Silicon carbide (SiC), as an emerging third-generation semiconductor core material, has the advantages of large band gap, high critical breakdown electric field intensity, high electron mobility, good radiation resistance and chemical stability and the like, which makes it a widely-applied important substrate wafer material. It has good application prospects in the fields of aviation devices, new energy vehicles, rail transit, household appliances and the like.

At present, silicon carbide crystals grow mainly by physical vapor transport (PVT), however, the inventor found that in growth apparatuses in the prior art, mostly, a crucible cover is fixed to a crucible after seed crystals are bonded to the crucible cover, thus forming a sealed "black box" structure, the growth condition of crystals inside is hardly acquired, and the growth rate and weight of crystals are hardly monitored.

### SUMMARY

The objective of the present disclosure is to, for example, provide an apparatus and method for growing silicon carbide, which can directly measure weights of grown crystals, precisely monitor the growth rate and weight of crystals, adjust processes based on this, and therefore improve the growth quality of silicon carbide crystals.

Embodiments of the present disclosure may be achieved as follows:
In a first aspect, the present disclosure provides an apparatus for growing silicon carbide, including:
a growth crucible, the growth crucible having an opening and being configured to accommodate silicon carbide powder;
a heating apparatus, the heating apparatus being arranged around the growth crucible and configured to heat the growth crucible;
a seed crystal positioning cover, the seed crystal positioning cover being arranged at the opening and in clearance fit with an edge of the opening, and seed crystals being bonded to a bottom side of the seed crystal positioning cover and configured to grow silicon carbide crystals;
a positioning frame, at least part of the positioning frame extending above the growth crucible;
a weighing apparatus, the weighing apparatus being fixedly arranged on a portion, extending above the growth crucible, of the positioning frame; and
a bearing connector, one end of the bearing connector being connected with a top side of the seed crystal positioning cover, and the other end of the bearing connector being connected with the weighing apparatus;
wherein the weighing apparatus is configured to hoist the seed crystal positioning cover through the bearing connector and measure weights of the seed crystal positioning cover, the seed crystals and the silicon carbide crystals.

In an optional implementation, a gap between an edge of the seed crystal positioning cover and an edge of the opening is in a range of 0.1 mm to 10 mm.

In an optional implementation, a bent check curtain is further arranged on the edge of the seed crystal positioning cover, and the bent check curtain shields the gap between the edge of the seed crystal positioning cover and the edge of the opening.

In an optional implementation, an edge of the bent check curtain is in sealed joint with the growth crucible, and can slide relative to the growth crucible.

In an optional implementation, a diameter of the seed crystal positioning cover is greater than an internal diameter of the opening, the seed crystal positioning cover is arranged above the opening, the edge of the seed crystal positioning cover and the edge of the opening correspond to each other and are in clearance fit, and the bent check curtain covers an outer side of a top end of the growth crucible, and is in clearance fit with an outer wall of the growth crucible.

In an optional implementation, a diameter of the seed crystal positioning cover is less than an internal diameter of the opening, the seed crystal positioning cover is arranged inside the opening, the edge of the seed crystal positioning cover and the edge of the opening correspond to each other and are in clearance fit, the edge of the bent check curtain corresponds to the edge of the opening and shields the gap between the seed crystal positioning cover and the growth crucible, and the bent check curtain is in clearance fit with a top end of the growth crucible.

In an optional implementation, the bearing connector includes a screw, a threaded insert and a sleeve, a top end of the screw is connected with the weighing apparatus, an external thread is arranged on a peripheral surface of the screw, the threaded insert is arranged on the screw and connected with the screw in a threaded manner, the sleeve sleeves the screw, one end of the sleeve is connected with the threaded insert, the other end of the sleeve is connected to the seed crystal positioning cover, and the threaded insert is configured to adjust relative positions between the screw and the sleeve, so as to adjust relative positions between the seed crystal positioning cover and the growth crucible.

In an optional implementation, the bearing connector includes a first connecting rod, an electric push rod, a second connecting rod and a guiding barrel, a top end of the first connecting rod is connected with the weighing apparatus, the electric push rod is arranged at the other end of the first connecting rod, one end of the second connecting rod is connected with the electric push rod, the other end of the second connecting rod is connected to the seed crystal positioning cover, and the guiding barrel is arranged on the first connecting rod, and sleeves the electric push rod and the second connecting rod.

In a second aspect, the present disclosure provides a method for growing silicon carbide crystals, suitable for any apparatus for growing silicon carbide in the above implementations. The method for growing the silicon carbide crystals includes:
loading silicon carbide powder into an opening of a growth crucible;
arranging a seed crystal positioning cover with seed crystals at the opening, wherein an edge of the seed crystal positioning cover and an edge of the opening are in clearance fit, and making a bent check curtain on the edge of the seed crystal positioning cover shield a gap between the edge of the seed crystal positioning cover and the edge of the opening;
heating, by a heating apparatus, the growth crucible, and setting process parameters;
measuring, by a weighing apparatus, weights of the seed crystal positioning cover, the seed crystals and silicon carbide crystals in real time, so as to acquire the weight of the silicon carbide crystals in real time; and
adjusting the process parameters according to the weight of the silicon carbide crystals.

In a third aspect, the present disclosure further provides silicon carbide crystals, prepared through the above method for growing the silicon carbide.

The embodiments of the present disclosure have the following beneficial effects, for example:
According to the apparatus for growing the silicon carbide provided by the embodiment of the present disclosure, the seed crystal positioning cover is connected with the weighing apparatus through the bearing connector, and the seed crystal positioning cover and the growth crucible are in clearance fit, such that the growth crucible is prevented from supporting the seed crystal positioning cover, the weighing apparatus can hoist the seed crystal positioning cover through the bearing connector, and accordingly, the seed crystal positioning cover, the seed crystals and the grown silicon carbide crystals may only act on the weighing apparatus; the weights of the seed crystal positioning cover, the seed crystals and the silicon carbide crystals are measured in real time through the weighing apparatus, and the weights of the seed crystal positioning cover and the seed crystals are constant, such that the weight of the silicon carbide crystals can be precisely measured in real time. Compared with the prior art, the apparatus for growing the silicon carbide provided by the present disclosure can directly measure the weight of the grown crystals, precisely monitor the growth rate and weight of crystals, adjust processes based on this, and therefore improve the growth quality of the silicon carbide crystals.

### BRIEF DESCRIPTION OF THE DRAWINGS

In order to more clearly explain the technical solutions of embodiments of the present disclosure, drawings required to be used in the embodiments will be briefly described below. It should be understood that the following drawings only illustrate some embodiments of the present disclosure, and thus should not be regarded as limitations to the scope, and according to which, those ordinarily skilled in the art can also obtain other drawings without involving inventive efforts.
FIG. 1 is a schematic diagram of an overall structure of an apparatus for growing silicon carbide provided by a first embodiment of the present disclosure;
FIG. 2 is a schematic diagram of a local structure of an apparatus for growing silicon carbide provided by a first embodiment of the present disclosure;
FIG. 3 is a schematic diagram of a local structure of an apparatus for growing silicon carbide provided by another preferred embodiment of the present disclosure;
FIG. 4 is a schematic diagram of a connecting structure of a seed crystal positioning cover and a sleeve in FIG. 2;
FIG. 5 is a schematic structural diagram of an apparatus for growing silicon carbide provided by a second embodiment of the present disclosure;
FIG. 6 is a schematic diagram of another structure of an apparatus for growing silicon carbide provided by a second embodiment of the present disclosure;
FIG. 7 is a schematic structural diagram of an apparatus for growing silicon carbide provided by a third embodiment of the present disclosure; and
FIG. 8 is a step block diagram of a method for growing silicon carbide provided by a fourth embodiment of the present disclosure.

Reference signs: 100-apparatus for growing silicon carbide; 110-growth crucible; 111-opening; 120-heating apparatus; 130-seed crystal positioning cover; 131-seed crystal; 132-bent check curtain; 1321-flexible abutting part; 133-boss; 134-assembly groove; 135-through groove; 136-clamping ring groove; 137-clamping block; 140-positioning frame; 150-weighing apparatus; 160-bearing connector; 161-screw; 162-threaded insert; 163-sleeve; 164-check block; 165-first connecting rod; 166-electric push rod; 167-second connecting rod; 168-guiding barrel; 169-damping rod; 1691-first damping barrel; 1693-second damping barrel; and 200-furnace body.

### DETAILED DESCRIPTION OF THE EMBODIMENTS

In order to make the objectives, technical solutions and advantages of the embodiments of the present disclosure clearer, the technical solutions in the embodiments of the present disclosure will be described clearly and completely with reference to the drawings in the embodiments of the present disclosure. Apparently, the described embodiments are part of the embodiments, not all of the embodiments. The components of the embodiments of the present disclosure generally described and illustrated in the drawings herein may be arranged and designed in a wide variety of different configurations.

Thus, the following detailed description of the embodiments of the present disclosure, as presented in the drawings, is not intended to limit the scope of the present disclosure, as claimed, but is merely representative of selected embodiments of the present disclosure. All other embodiments obtained by those ordinarily skilled in the art based on the embodiments of the present disclosure without involving inventive efforts should fall within the protection scope of the present disclosure.

It should be noted that like reference numerals and letters denote like items in the following drawings, and thus once an item is defined in one drawing, no further definition or explanation thereof is necessary in the following drawings.

In the description of the present disclosure, it should be understood that orientation or position relationships indicated by terms "upper", "lower", "inner", "outer", and the like are orientation or position relationships shown in the drawings, or orientation or position relationships based on which products of the present disclosure are usually placed, are adopted not to indicate or imply that indicated apparatuses or elements must be in specific orientations or structured and operated in specific orientations but only to conveniently describe the present disclosure and simplify the description, and thus should not be understood as a limitation to the present disclosure.

In addition, terms "first", "second", and the like are merely used for distinguishing between descriptions and should not be understood as the indication or implication of relative importance.

As disclosed in the background, in the field of growing silicon carbide crystals through PVT, the prior art is usually achieved through a fixed crucible, that is, a crucible cover usually covers a crucible body in a threaded or buckled manner, and seed crystals are bonded to an inner side of the crucible cover, as a result, the crucible cover is supported by the crucible body. By the adoption of such solution, a sealed "black box" structure will be formed, such that the growth condition of crystals inside the crucible cannot be visually monitored from the outside.

Furthermore, there is a solution for weighing the crucible, or weighing the remaining powder at a bottom, that is, the growth amount of the crystals is calculated based on the amount of the remaining powder. However, due to losses of the powder in the crystal growth process, it is not accurate to calculate the weight of the crystals through the powder, and the obtained growth amount of the crystals is not accurate, and it is also difficult to monitor the growth rate and weight of crystals.

In order to solve the above problems, the present disclosure provides an apparatus for growing silicon carbide, a method for growing silicon carbide, and silicon carbide crystals. It should be noted that the features in the embodiments of the present disclosure may be mutually combined without conflicts.

### First Embodiment

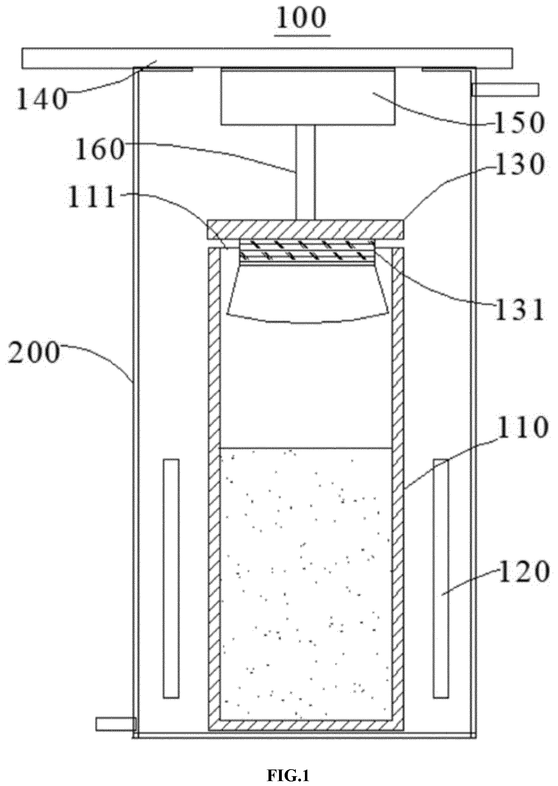

Referring to FIG. 1, this embodiment provides an apparatus 100 for growing silicon carbide, which can directly measure the weight of grown crystals, precisely monitor the rate and weight of crystal growth, adjust processes based on this, and therefore improve the growth quality of the silicon carbide crystals.

The apparatus 100 for growing the silicon carbide provided by this embodiment, includes: a growth crucible 110, a heating apparatus 120, a seed crystal positioning cover 130, a positioning frame 140, a weighing apparatus 150 and a bearing connector 160, wherein the growth crucible 110 has an opening 111 and is configured to accommodate silicon carbide powder; the heating apparatus 120 is arranged around the growth crucible 110 and configured to heat the growth crucible 110; the seed crystal positioning cover 130 is arranged at the opening 111 and in clearance fit with an edge of the opening 111, and seed crystals 131 are bonded to a bottom side of the seed crystal positioning cover 130 and are configured to grow silicon carbide crystals; at least part of the positioning frame 140 extends above the growth crucible 110; the weighing apparatus 150 is fixedly arranged on a portion, extending above the growth crucible 110, of the positioning frame 140; one end of the bearing connector 160 is connected with a top side of the seed crystal positioning cover 130, and the other end of the bearing connector is connected with the weighing apparatus 150; wherein the weighing apparatus 150 is configured to hoist the seed crystal positioning cover 130 through the bearing connector 160 and measure weights of the seed crystal positioning cover 130, the seed crystals 131 and the silicon carbide crystals.

In this embodiment, the apparatus 100 for growing the silicon carbide may be a growth furnace, the growth crucible 110 is arranged inside a furnace body 200, the positioning frame 140 is arranged on a top of the furnace body 200 and extends over the growth crucible 110, and the weighing apparatus 150 is fixedly arranged on the positioning frame 140, so as to weigh components below. Other internal components of the growth furnace may refer to an existing furnace for growing the silicon carbide, which are not described in detail here.

It should be noted that in this embodiment, the seed crystal positioning cover 130 is connected with the weighing apparatus 150 through the bearing connector 160, and the seed crystal positioning cover 130 and the growth crucible 110 are in clearance fit, such that the growth crucible 110 is prevented from supporting the seed crystal positioning cover 130, the weighing apparatus 150 can hoist the seed crystal positioning cover 130 through the bearing connector 160, and accordingly, the seed crystal positioning cover 130, the seed crystals 131 and the grown silicon carbide crystals may only act on the weighing apparatus 150; the weights of the seed crystal positioning cover 130, the seed crystals 131 and the silicon carbide crystals are measured in real time through the weighing apparatus 150, and the weights of the seed crystal positioning cover 130 and the seed crystals 131 are constant, such that the weight of the silicon carbide crystals can be precisely measured in real time, the growth rate and weight of crystals can be precisely monitored accordingly, processes can be adjusted based on this, and therefore the growth quality of the silicon carbide crystals is improved.

In this embodiment, the weighing apparatus 150 includes an electronic scale and a display screen (not shown), the electronic scale is fixedly arranged on the positioning frame 140 and connected with the bearing connector 160, and the display screen is in communication connection with the electronic scale. Specifically, the weighing precision of the electronic scale may be less than 1 g, which is high. The display screen may be arranged on an outer side of the positioning frame 140 and exposed out of the growth furnace, and weighing data of the electronic scale may be directly shown through the display screen, such that a worker can conveniently monitor readings of the electronic scale in real time.

Furthermore, a growth rate may be displayed on the display screen. Specifically, the weight and growth rate of the silicon carbide crystals can be calculated by analyzing the readings of the electronic scale and time and displayed on the display screen, such that process parameters can be conveniently and better adjusted. For example, the display screen displays the low weight and growth rate of the silicon carbide crystals, the process parameters beneficial for growth can be adjusted, for example, a heating temperature is increased or a temperature gradient is adjusted, so as to further increase the growth rate of the crystals.

In this embodiment, a gap L1 between an edge of the seed crystal positioning cover 130 and an edge of the opening 111 is in a range of 0.1 mm to 10 mm. Preferably, the gap L1 between the edge of the seed crystal positioning cover 130 and the edge of the opening 111 is 1 mm. Losses of the silicon carbide powder and the weighing precision can be balanced by reasonably controlling the gap L1 here. If the gap is too small, for example, the gap is less than 0.1 mm, it will result in an excessively small distance between the seed crystal positioning cover 130 and the growth crucible 110, leading to interference, and the growth crucible 110 will affect the hoisting state of the seed crystal positioning cover 130, so as to affect the weighing precision; and if the gap is too large, for example, the gap is greater than 10 mm, there will be excessive losses of the powder, affecting the crystallization speed and quality.

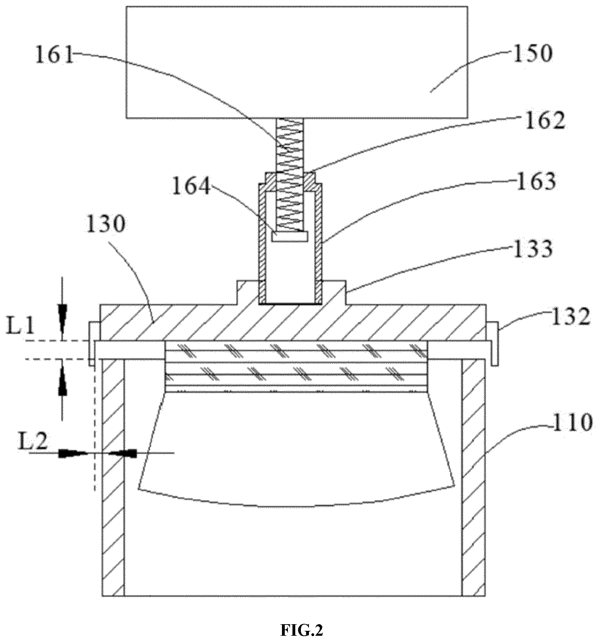

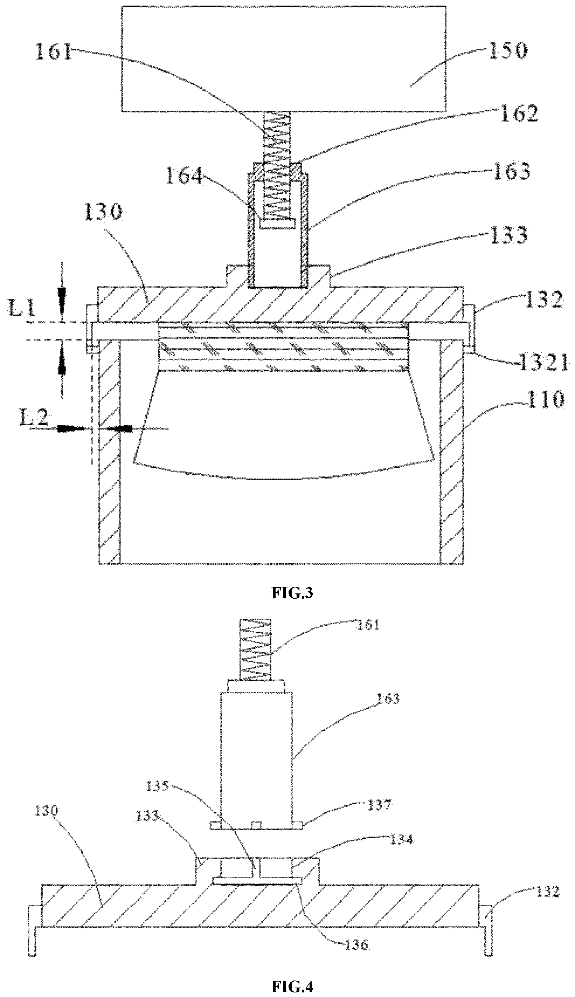

Referring to FIG. 2 and FIG. 4, in this embodiment, a diameter of the seed crystal positioning cover 130 is greater than an internal diameter of the opening 111, the seed crystal positioning cover 130 is arranged above the opening 111, and the edge of the seed crystal positioning cover 130 and the edge of the opening 111 correspond to each other and are in clearance fit. Specifically, the diameter of the seed crystal positioning cover 130 is matched with an external diameter of the growth crucible 110, such that the seed crystal positioning cover 130 can completely shield the opening 111 of the growth crucible 110 in a vertical direction, thereby ensuring enough adhesion space for the seed crystals 131.

In this embodiment, the bearing connector 160 includes a screw 161, a threaded insert 162 and a sleeve 163, a top end of the screw 161 is connected with the weighing apparatus 150, an external thread is arranged on a peripheral surface of the screw 161, the threaded insert 162 is arranged on the screw 161 and connected with the screw 161 in a threaded manner, the sleeve 163 sleeves the screw 161, one end of the sleeve 163 is connected with the threaded insert 162, the other end of the sleeve is connected to the seed crystal positioning cover 130, and the threaded insert 162 is configured to adjust relative positions between the screw 161 and the sleeve 163, so as to adjust relative positions between the seed crystal positioning cover 130 and the growth crucible 110. Specifically, the threaded insert 162 is integrally arranged at a top end of the sleeve 163, and a bottom end of the sleeve 163 is fixedly connected to a top side of the seed crystal positioning cover 130. During actual installation, the sleeve 163 and the threaded insert 162 can be driven to rotate relative to the screw 161 by rotating the seed crystal positioning cover 130, so as to adjust the relative positions between the seed crystal positioning cover 130 and the growth crucible 110, and it is ensured that the gap between the seed crystal positioning cover 130 and the growth crucible 110 is in the range of 0.1 mm to 10 mm.

It is worth noting that in this embodiment, in order to ensure that the gap between the seed crystal positioning cover 130 and the growth crucible 110 is precisely controlled at 1 mm, it can be determined through rotation turns. Specifically, a thread pitch of an external thread on the screw 161 may be 0.5 mm, such that the distance adjusted by rotating the seed crystal positioning cover 130 by one turn is 0.5 mm. During actual installation, the seed crystal positioning cover 130 may be firstly rotated forward, the seed crystal positioning cover 130 is adjusted to an extreme position downward, where the seed crystal positioning cover 130 abuts against the growth crucible 110. Subsequently, the seed crystal positioning cover 130 is rotated reversely by two turns, and therefore it can be ensured that the gap between the seed crystal positioning cover 130 and the growth crucible 110 is precisely controlled at 1 mm.

In this embodiment, a check block 164 is further arranged at a bottom end of the screw 161, and a size of the check block 164 is greater than an internal diameter of the threaded insert 162, such that the sleeve 163 and the threaded insert 162 can be prevented from disengaging from the screw 161.

In this embodiment, a bent check curtain 132 is further arranged on a periphery of the seed crystal positioning cover 130, and the bent check curtain 132 covers an outer side of a top end of the growth crucible 110, and is in clearance fit with an outer wall of the growth crucible 110. Specifically, a material of the bent check curtain 132 may be consistent with that of the seed crystal positioning cover 130, the bent check curtain extends outward from the periphery of the seed crystal positioning cover 130 and is bent downward, and the bent check curtain 132 can just shield the gap between the seed crystal positioning cover 130 and the growth crucible 110 after the seed crystal positioning cover 130 is adjusted in place, such that gaseous substances inside the growth crucible 110 are prevented from overflowing massively, further reducing losses of the silicon carbide powder.

It should be noted that in this embodiment, the bent check curtain 132 is integrally arranged on the periphery of the seed crystal positioning cover 130, a groove may be formed in an inner side of the seed crystal positioning cover 130 in a surrounding manner, and a size of the groove may be matched with that of the growth crucible 110 and slightly greater than the external diameter of the growth crucible 110. During actual assembly, the growth crucible 110 can be guided and aligned by the bent check curtain 132, such that the growth crucible 110 and the seed crystal positioning cover 130 can be aligned, thereby ensuring the assembly precision.

Furthermore, in this embodiment, a gap L2 between the bent check curtain 132 and the outer wall of the growth crucible 110 may also be in the range of 0.1 mm to 10 mm, on one hand, the growth crucible 110 can be prevented from interfering with the seed crystal positioning cover 130, and on the other hand, the gaseous substances can be prevented from overflowing massively, thereby reducing the losses of the silicon carbide powder.

In another preferred embodiment of the present disclosure, referring to FIG. 3, an edge of the bent check curtain 132 is in sealed joint with the growth crucible 110, and can slide relative to the growth crucible 110. Specifically, a flexible abutting part 1321 may be arranged on an edge of a bottom side of the bent check curtain 132, and the flexible abutting part 1321 may be graphite paper, which abuts against the outer wall of the growth crucible 110, so as to further prevent the gaseous substances from overflowing. Moreover, due to low weight and soft texture of the graphite paper, it can be confirmed that the graphite paper may freely slide against the growth crucible 110 and cannot affect the precision of the weighing apparatus 150.

In this embodiment, since the seed crystal positioning cover 130 is not supported by the growth crucible 110, the weights of the seed crystal positioning cover 130, the seed crystals 131 and the silicon carbide crystals are all centralized on the bearing connector 160. Therefore, a joint between the threaded insert 162 and the seed crystal positioning cover 130 has to be reinforced, preferably, a center of the top side of the seed crystal positioning cover 130 may locally bulge to form a boss 133, an assembly groove 134 is formed in the boss 133, and the sleeve 163 is assembled in the thread groove, thereby achieving the fixation between the sleeve 163 and the seed crystal positioning cover 130. Specifically, herein, a through groove 135 may be formed in a side wall of the assembly groove 134, a clamping ring groove 136 is formed in a bottom side of the through groove 135, a clamping block 137 is arranged on a periphery of the bottom end of the sleeve 163, and the clamping block 137 may be inserted into the clamping ring groove 136 along the through groove 135, thereby achieving the fixation between the sleeve 163 and the assembly groove 134. Moreover, in order to prevent the clamping block 137 from loosening in the process of rotating the seed crystal positioning cover 130, interference fit between the clamping ring groove 136 and the clamping block 137 needs to be ensured herein.

Furthermore, in order to prevent the boss 133 from affecting the heat uniformity of the seed crystal positioning cover 130, a heat insulating layer may be arranged around the boss 133 herein, and heat conduction properties at all positions of the seed crystal positioning cover 130 may be similar by adjusting a thickness of the heat insulating layer, thereby ensuring the heat uniformity.

In conclusion, this embodiment provides the apparatus 100 for growing the silicon carbide, the seed crystal positioning cover 130 is connected with the weighing apparatus 150 through the bearing connector 160, and the seed crystal positioning cover 130 and the growth crucible 110 are in clearance fit, such that the growth crucible 110 is prevented from supporting the seed crystal positioning cover 130, the weighing apparatus 150 can hoist the seed crystal positioning cover 130 through the bearing connector 160, and accordingly, the seed crystal positioning cover 130, the seed crystals 131 and the grown silicon carbide crystals may only act on the weighing apparatus 150; the weights of the seed crystal positioning cover 130, the seed crystals 131 and the silicon carbide crystals are measured in real time through the weighing apparatus 150, and the weights of the seed crystal positioning cover 130 and the seed crystals 131 are constant, such that the weight of the silicon carbide crystals can be precisely measured in real time, processes can be adjusted based on this, and therefore the growth quality of the silicon carbide crystals is improved.

### Second Embodiment

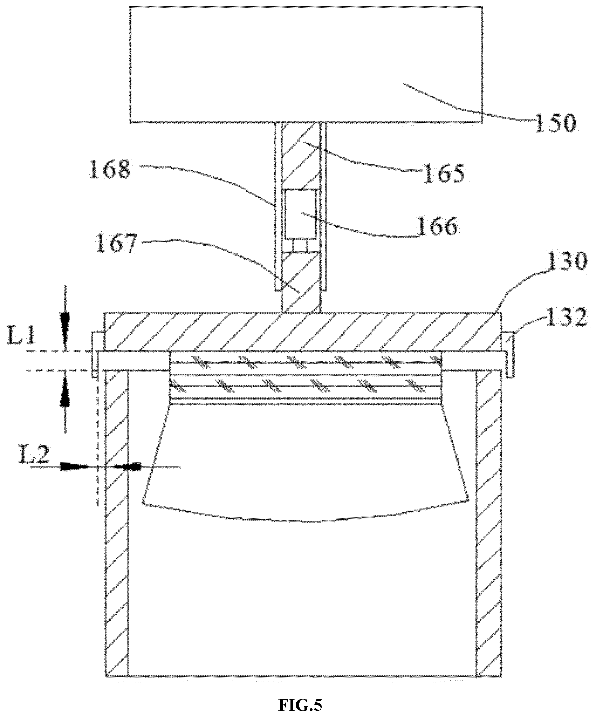

Referring to FIG. 5, this embodiment provides an apparatus 100 for growing silicon carbide. A basic structure, principle and technical effects of the apparatus are the same as those of the first embodiment, and for a brief description, parts not mentioned in this embodiment may refer to the corresponding parts in the first embodiment.

In this embodiment, the bearing connector 160 includes a first connecting rod 165, an electric push rod 166, a second connecting rod 167 and a guiding barrel 168, a top end of the first connecting rod 165 is connected with a weighing apparatus 150, the electric push rod 166 is arranged at the other end of the first connecting rod 165, one end of the second connecting rod 167 is connected with the electric push rod 166, the other end of the second connecting rod is connected to the seed crystal positioning cover 130, and the guiding barrel 168 is arranged on the first connecting rod 165, and sleeves the electric push rod 166 and the second connecting rod 167. Specifically, the second connecting rod 167 may be automatically adjusted vertically by arranging the electric push rod 166, such that a distance between a seed crystal positioning cover 130 and a growth crucible 110 is adjusted, which is very convenient. Moreover, the second connecting rod 167 may be assembled in the guiding barrel 168 by arranging the guiding barrel 168, and the second connecting rod 167 can be guided and limited, such that a motion trail of the second connecting rod 167 is prevented from being affected by horizontal moment generated by the electric push rod 166, thereby ensuring the assembly precision of the seed crystal positioning cover 130.

In this embodiment, in order to ensure that the gap L1 between the seed crystal positioning cover 130 and the growth crucible 110 is in a range of 0.1 mm to 10 mm, for example, the gap is precisely controlled at 1 mm, similarly, the second connecting rod 167 may be firstly pushed to an extreme position downward by the electric push rod 166, where the seed crystal positioning cover 130 abuts against the growth crucible 110, then the second connecting rod 167 is pushed upward by 1 mm by the electric push rod 166, and it can be ensured that the gap between the seed crystal positioning cover 130 and the growth crucible 110 is precisely controlled at 1 mm through precise propulsion of the electric push rod 166.

It should be noted that a basic structure of the electric push rod 166 in this embodiment may refer to the prior art, and the electric push rod may be connected with an external power source after a wire penetrates through the first connecting rod 165, so as to achieve power supply. Herein, a start action of the electric push rod 166 may be calibrated, for example, after the electric push rod 166 is started, the second connecting rod 167 will always restore by 1 mm after being pushed to a lowest end by the electric push rod, achieving precise control over the seed crystal positioning cover 130. Of course, the value of the gap may be adjusted according to actual conditions herein, and a value of the electric push rod 166 for restoration may also be adaptively adjusted.

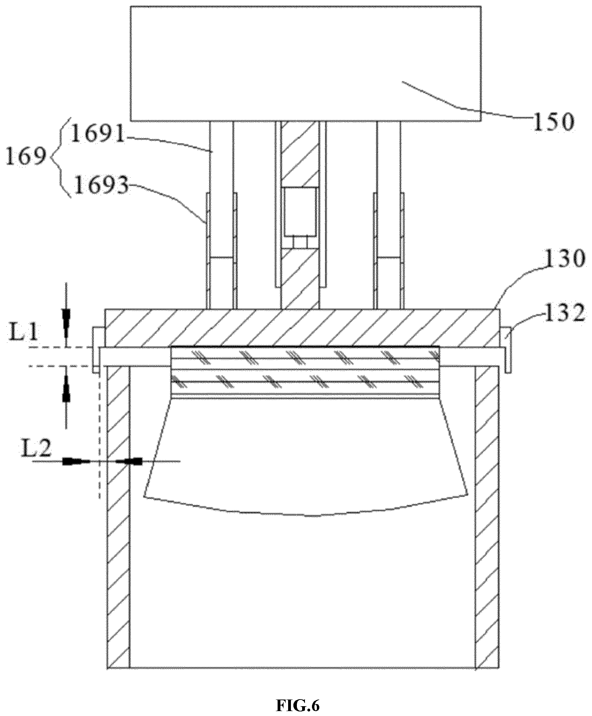

Referring to FIG. 6, furthermore, a weight of silicon carbide crystals will be increased in the growth process, resulting in the increase in force borne by the bearing connector 160. In order to prevent normal operation of the electric push rod 166 from being affected by excessive dragging of the electric push rod 166, in another preferred embodiment of the present disclosure, a plurality of damping rods 169 may be uniformly arranged around the bearing connector 160, and the plurality of damping rods 169 can provide certain damping in the moving process of the seed crystal positioning cover 130, and continuously provides the damping after the seed crystal positioning cover 130 is fixed, so as to share certain acting force for the bearing connector 160.

In this embodiment, the weighing apparatus 150 may be provided with a bearing plate, and the bearing plate is connected with the bearing connector 160 below the bearing plate. Each damping rod 169 includes a first damping barrel 1691 and a second damping barrel 1693, one end of the first damping barrel 1691 is connected with the bearing plate, the other end of the first damping barrel extends downward, one end of the second damping barrel 1693 sleeves the first damping barrel 1691, the other end of the second damping barrel is connected with the seed crystal positioning cover 130, an outer wall of the first damping barrel 1691 directly makes contact with an inner wall of the second damping barrel 1693, small protrusions are arranged on an exterior of the first damping barrel 1691 and the inner wall of the second damping barrel 1693, and friction force between the first damping barrel 1691 and the second damping barrel 1693 is increased, thereby providing certain damping. By arranging the first damping barrel 1691 and the second damping barrel 1693, connection friction force allowed for the motion of the seed crystal positioning cover can be provided after the seed crystal positioning cover 130 is fixed in position, such that tensile stress borne by the bearing connector 160 is dispersed. In addition, the first damping barrel 1691 and the second damping barrel 1693 may further have a certain guiding effect, so as to further prevent the motion trail of the second connecting rod 167 from being affected by the horizontal moment generated by the electric push rod 166, thereby ensuring the assembly precision of the seed crystal positioning cover 130.

It should be noted that herein, the friction force between the first damping barrel 1691 and the second damping barrel 1693 is far less than driving force provided by the electric push rod 166, such that the electric push rod 166 and the seed crystal positioning cover 130 cannot be affected by the friction force between the first damping barrel 1691 and the second damping barrel 1693 when the electric push rod 166 is in operation.

According to the apparatus 100 for growing the silicon carbide provided by the present disclosure, the seed crystal positioning cover 130 can be adjusted accurately at high precision through the structure of the electric push rod 166, and the assembly precision of the seed crystal positioning cover 130 can be ensured.

### Third Embodiment

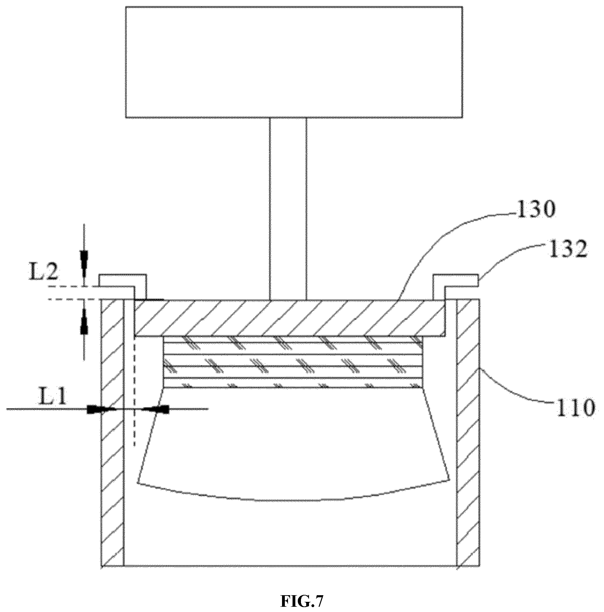

Referring to FIG. 7, this embodiment provides an apparatus 100 for growing silicon carbide. A basic structure, principle and technical effects of the apparatus are the same as those of the first embodiment, and for brief description, parts not mentioned in this embodiment may refer to the corresponding parts in the first embodiment.

In this embodiment, a diameter of a seed crystal positioning cover 130 is less than an internal diameter of an opening 111, the seed crystal positioning cover 130 is arranged inside the opening 111, and an edge of the seed crystal positioning cover 130 and an edge of the opening 111 correspond to each other and are in clearance fit. Specifically, the seed crystal positioning cover 130 may be just assembled on an inner side of the opening 111 of a growth crucible 110, moreover, a top side of the seed crystal positioning cover 130 may be flush with a top end of the growth crucible 110, as a result, a periphery of the seed crystal positioning cover 130 and an inner wall of the growth crucible 110 are in clearance fit, and similarly, the growth crucible 110 can be prevented from supporting and limiting the seed crystal positioning cover 130.

In this embodiment, a gap L1 between the periphery of the seed crystal positioning cover 130 and the inner wall of the growth crucible 110 may also be in a range of 0.1 mm to 10 mm, and preferably, 1 mm. Since in this embodiment, sizes of the seed crystal positioning cover 130 and the growth crucible 110 are constant, it can be ensured that the gap is within the preset range only by ensuring that the seed crystal positioning cover 130 is precisely loaded into the opening 111 during actual assembly, and therefore the assembly precision between the seed crystal positioning cover 130 and the growth crucible 110 is higher without a complex precise positioning manner. Losses of silicon carbide powder and the weighing precision are balanced by reasonably controlling the gap herein.

In this embodiment, a bent check curtain 132 is further arranged on an edge of a top side of the seed crystal positioning cover 130, the bent check curtain 132 corresponds to an edge of the opening 111 and shields the gap between the seed crystal positioning cover 130 and the growth crucible 110, and the bent check curtain 132 is in clearance fit with the top end of the growth crucible 110. Specifically, the bent check curtain 132 is integrally arranged on the edge of the top side of the seed crystal positioning cover 130 and bent upward and outward. Preferably, the bent check curtain 132 is annularly distributed on the edge of the seed crystal positioning cover 130, and an external diameter of the bent check curtain 132 is the same as that of the growth crucible 110, such that the bent check curtain 132 can completely shield the gap between the seed crystal positioning cover 130 and the inner wall of the growth crucible 110. Gaseous substances inside the growth crucible 110 can be prevented from overflowing massively by arranging the bent check curtain 132, thereby further reducing the losses of the silicon carbide powder.

It should be noted that in this embodiment, since the gap between the seed crystal positioning cover 130 and the growth crucible 110 is vertically formed and directly communicated with an interior of the growth crucible 110, and the silicon carbide powder inside the growth crucible 110 will vertically and upward move to seed crystals 131 under an action of a temperature gradient after being sublimated under a high-temperature action, an airflow direction inside the growth crucible 110 is also vertically upward, the powder will directly overflow from the gap, and the overflowing rate is high, resulting in huge losses of the powder. Thus, in this embodiment, vertically upward airflow can be blocked by arranging the bent check curtain 132, so as to achieve slow flow, a large quantity of gaseous substances are prevented from rapidly flowing outward, and the losses of the powder are effectively reduced.

In this embodiment, a gap L2 between the bent check curtain 132 and the top end of the growth crucible 110 may also be in the range of 0.1 mm to 10 mm, and preferably, 1 mm. Specifically, herein, a manner for controlling the gap between the bent check curtain 132 and the growth crucible 110 may refer to a manner for reverse rotating after positioning in the first embodiment, which is not repeated here. Correspondingly, herein, the gap between the bent check curtain 132 and the growth crucible 110 requires low precision, which may also be directly positioned visually.

According to the apparatus 100 for growing the silicon carbide provided by this embodiment, the precise gap between the seed crystal positioning cover 130 and the growth crucible 110 always exists by the adoption of the embedded seed crystal positioning cover 130, a complex positioning solution is not needed, and therefore higher simplicity and convenience are achieved.

### Fourth Embodiment

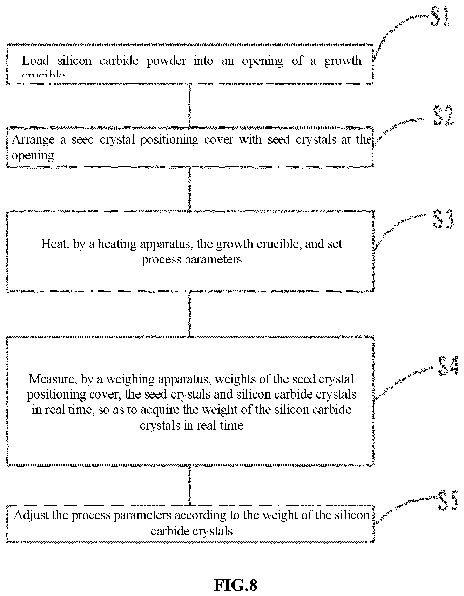

Referring to FIG. 8, this embodiment provides a method for growing silicon carbide, suitable for the apparatus 100 for growing the silicon carbide in the first embodiment, the second embodiment or the third embodiment. The method for growing the silicon carbide includes the following steps:
S1: silicon carbide powder is loaded into an opening 111 of a growth crucible 110.

Specifically, the loading silicon carbide powder may be loaded into the opening 111, and the use amount of the silicon carbide powder may refer to a conventional solution for growing the silicon carbide.

S2: a seed crystal positioning cover 130 with seed crystals 131 is arranged at the opening 111.

Specifically, the seed crystals 131 may be pre-bonded to the seed crystal positioning cover 130, wherein an edge of the seed crystal positioning cover 130 and an edge of the opening 111 are in clearance fit. During actual assembly, a gap may be adjusted through a bearing connector 160, which is set in a range of 0.1 mm to 10 mm, and preferably, about 1 mm.

S3: the growth crucible 110 is heated by a heating apparatus 120, and process parameters are set.

Specifically, the growth crucible 110 may be heated by the heating apparatus 120, and the process parameters such as a temperature and a pressure are set. Wherein before heating, vacuum may be pumped from a growth furnace and the growth crucible 110 to a level of 5×10⁻⁶ mpar or below, then the growth furnace and the growth crucible are filled with process gas, and the process gas may be one or more of argon, nitrogen, hydrogen, helium and the like. The pressure in the growth crucible 110 is kept at 1-800 mbar, then the growth crucible 110 is heated by the heating apparatus 120, the silicon carbide powder is sublimated into gas after the temperature reaches 1,800-2,300°C, the gas flows from a high-temperature region to a low-temperature region along a temperature gradient, and silicon carbide monocrystals are deposited on growth surfaces of the seed crystals 131.

S4: weights of the seed crystal positioning cover 130, the seed crystals 131 and silicon carbide crystals are measured in real time by a weighing apparatus 150, so as to acquire the weight of the silicon carbide crystals in real time.

Specifically, the weight of the silicon carbide crystals can be acquired in real time by the weighing apparatus 150 in the growth process, such that the growth rate of the silicon carbide crystals is monitored in real time.

S5: the process parameters are adjusted according to the weight of the silicon carbide crystals.

Specifically, the corresponding process parameters, such as the temperature or pressure, can be fed back and adjusted according to the weight change condition and growth rate of the silicon carbide crystals, such that the silicon carbide crystals tend to grow more stably and efficiently.

This embodiment further provides silicon carbide crystals, prepared through the above method for growing the silicon carbide crystals. The preparation efficiency and the quality of the crystals are high.

In conclusion, according to the method for growing the silicon carbide provided by this embodiment, the seed crystal positioning cover 130 and the growth crucible 110 are in clearance fit, such that the growth crucible 110 is prevented from supporting the seed crystal positioning cover 130, the weighing apparatus 150 can hoist the seed crystal positioning cover 130 through the bearing connector 160, and accordingly, the seed crystal positioning cover 130, the seed crystals 131 and the grown silicon carbide crystals may only act on the weighing apparatus 150; the weights of the seed crystal positioning cover 130, the seed crystals 131 and the silicon carbide crystals are measured in real time through the weighing apparatus 150, and the weights of the seed crystal positioning cover 130 and the seed crystals 131 are constant, such that the weight of the silicon carbide crystals can be precisely measured in real time, and the growth rate and weight of crystal can be precisely monitored, processes can be adjusted based on this accordingly, and therefore the growth quality of the silicon carbide crystals is improved.

The above descriptions are merely the detailed description of embodiments of the present disclosure, which are not intended to limit the protection scope of the present disclosure. Any change or replacement which is easily made by any person skilled in the art within the technical scope described in the present disclosure should fall within the protection scope of the present disclosure. Therefore, the protection scope of the disclosure should follow the protection scope of the claims.

## Claims

1. An apparatus for growing silicon carbide,
comprising a growth crucible (110), the growth crucible (110) having an opening (111) and being configured to accommodate silicon carbide powder;
a heating apparatus (120), the heating apparatus (120) being arranged around the growth crucible (110) and configured to heat the growth crucible (110);
a seed crystal positioning cover (130), the seed crystal positioning cover (130) being arranged at the opening (111) and in clearance fit with an edge of the opening (111), and seed crystals (131) being bonded to a bottom side of the seed crystal positioning cover (130) and configured to grow silicon carbide crystals;
a positioning frame (140), at least part of the positioning frame (140) extending above the growth crucible (110);
a weighing apparatus (150), the weighing apparatus (150) being fixedly arranged on a portion, extending above the growth crucible (110), of the positioning frame (140); and
a bearing connector (160), one end of the bearing connector (160) being connected with a top side of the seed crystal positioning cover (130), and the other end of the bearing connector being connected with the weighing apparatus (150);
wherein the weighing apparatus (150) is configured to hoist the seed crystal positioning cover (130) through the bearing connector (160) and measure weights of the seed crystal positioning cover (130), the seed crystals (131) and the silicon carbide crystals; and
a bent check curtain (132) is further arranged on an edge of the seed crystal positioning cover (130), and the bent check curtain (132) shields a gap between the edge of the seed crystal positioning cover (130) and the edge of the opening (111).

2. The apparatus for growing the silicon carbide according to claim 1, wherein
an edge of the bent check curtain (132) is in sealed joint with the growth crucible (110), and is allowed to slide relative to the growth crucible (110).

3. The apparatus for growing the silicon carbide according to claim 1, wherein
a diameter of the seed crystal positioning cover (130) is greater than an internal diameter of the opening (111), the seed crystal positioning cover (130) is arranged above the opening (111), the edge of the seed crystal positioning cover (130) and the edge of the opening (111) correspond to each other and are in clearance fit, and the bent check curtain (132) covers an outer side of a top end of the growth crucible (110), and is in clearance fit with an outer wall of the growth crucible (110).

4. The apparatus for growing the silicon carbide according to claim 1, wherein
a diameter of the seed crystal positioning cover (130) is less than an internal diameter of the opening (111), the seed crystal positioning cover (130) is arranged inside the opening (111), the edge of the seed crystal positioning cover (130) and the edge of the opening (111) correspond to each other and are in clearance fit, the edge of the bent check curtain (132) corresponds to the edge of the opening (111) and shields the gap between the seed crystal positioning cover (130) and the growth crucible (110), and the bent check curtain (132) is in clearance fit with a top end of the growth crucible (110).

5. The apparatus for growing the silicon carbide according to claim 3 or 4, wherein
the bearing connector (160) comprises a screw (161), a threaded insert (162) and a sleeve (163), a top end of the screw (161) is connected with the weighing apparatus (150), an external thread is arranged on a peripheral surface of the screw (161), the threaded insert (162) is arranged on the screw (161) and connected with the screw (161) in a threaded manner, the sleeve (163) sleeves the screw (161), one end of the sleeve (163) is connected with the threaded insert (162), the other end of the sleeve is connected to the seed crystal positioning cover (130), and the threaded insert (162) is configured to adjust relative positions between the screw (161) and the sleeve (163), so as to adjust relative positions between the seed crystal positioning cover (130) and the growth crucible (110).

6. The apparatus for growing the silicon carbide according to claim 3 or 4, wherein
the bearing connector (160) comprises a first connecting rod (165), an electric push rod (166), a second connecting rod (167) and a guiding barrel (168), a top end of the first connecting rod (165) is connected with the weighing apparatus (150), the electric push rod (166) is arranged at the other end of the first connecting rod (165), one end of the second connecting rod (167) is connected with the electric push rod (166), the other end of the second connecting rod is connected to the seed crystal positioning cover (130), and the guiding barrel (168) is arranged on the first connecting rod (165), and sleeves the electric push rod (166) and the second connecting rod (167).

7. A method for growing silicon carbide, comprising the following steps:
loading silicon carbide powder into an opening (111) of a growth crucible (110);
arranging a seed crystal positioning cover (130) with seed crystals (131) at the opening (111), wherein an edge of the seed crystal positioning cover (130) and an edge of the opening (111) are in clearance fit, and making a bent check curtain (132) on the edge of the seed crystal positioning cover (130) shield a gap between the edge of the seed crystal positioning cover (130) and the edge of the opening (111);
heating, by a heating apparatus (120), the growth crucible (110), and setting process parameters;
measuring, by a weighing apparatus (150), a weight of the seed crystal positioning cover (130), a weight of the seed crystals (131) and a weight of silicon carbide crystals in real time, so as to acquire the weight of the silicon carbide crystals in real time; and
adjusting the process parameters according to the weight of the silicon carbide crystals.
